# EUROPEAN PATENT SPECIFICATION

(11) **EP 1 210 395 B1**
(45) Date of publication and mention of the grant of the patent: **22.10.2003**
(21) Application number: 00955837.0
(22) Date of filing: 23.08.2000
(51) Int. Cl.: C09K 3/14, H01L 21/302, C09G 1/02

(54) **COMPOSITIONS FOR INSULATOR AND METAL CMP AND METHODS RELATING THERETO**
ZUSAMMENSETZUNG UND VERFAHREN ZUM CHEMISCH-MECHANISCHEN POLIEREN VON ISOLATOREN UND METALLEN
COMPOSITIONS POUR ISOLANT ET CMP DE METAL, ET PROCEDES ASSOCIES

(30) Priority: 24.08.1999 US 150443 P; 11.08.2000 US 224686 P
(43) Date of publication of application: 05.06.2002
(73) Proprietor: Rodel Holdings, Inc., Wilmington, DE 19899 (US)
(72) Inventor: COSTAS, Wesley, D., Bear, DE 19701 (US); SHEN, James, PORTLAND, OR 97229 (US); MANDIGO, Glenn, C., Boothwyn, PA 19061 (US); THOMAS, Terence, M., Newark, DE 19711 (US); LACK, Craig, D., Wilmington, DE 19808 (US); BARKER, Ross, E., II, Newark, DE 19713 (US)
(74) Representative: Carpmaels & Ransford
(86) International application number: US0023052
(87) International publication number: WO01014496

(56) References cited:
- EP-A- 0 913 442
- US-A- 4 752 628
- US-A- 5 352 277
- US-A- 5 704 987
- US-A- 5 860 848

## Description

### BACKGROUND OF THE INVENTION

### Field of the invention

The present invention relates to the polishing and planarization of integrated circuit surfaces, particularly those comprising silicon dioxide films (TEOS, thermal oxide or BPSG), low-K ILD films, silicon nitride films, metal films (lines) and the mixtures of these.

### Discussion of Related Art

CMP is an enabling technology used in the semiconductor industry to remove/planarize various thin films from the surface of semiconductor substrates during the production of IC. Various types of abrasives have been used for CMP. The polishing pad, typically made of polymer materials, is another important part in the CMP process. Particles of silicon dioxide, metal oxide (alumina, ceria, titania and ziconia etc.) or a mixture of the like are typically used as the abrasive in CMP slurries.

Achieving IC wafer planarization with smooth, scratch-free and low defect surfaces is greatly challenged by the presence of abrasive particles and the micro-asperities of the polymer pads. A CMP slurry which is not properly formulated will generate scratches and residues on the polished surfaces. The scratches may result from the trace tracks of the particles (slurry abrasives and residue from removed materials), while the residue coating may come from the gelled slurries and the redeposition of the removed materials (metal oxide in the case of metal CMP and silanol or silicates in the case of silicon oxide CMP.) The dense scratching texture will heavily contribute to the higher level of roughness on the wafer surfaces. It has been observed that the slurry coating and re-deposition of residue will preferentially occur in the dense pattern areas, especially small features and interconnection lines in areas where the surface energy is high and the residue can be readily accommodated.

USP 5,704,987 addresses the problem of removing residual slurry particles adhered to a wafer surface after chemical-mechanical polishing. Proposed is a two step cleaning operation. The first step uses a basic aqueous solution of a nonionic polymeric surfactant; the second step uses purified water.

USP 5,783,489 discusses the use of surfactants, stabilizers, or dispersing agents to promote stabilization of a polishing slurry including oxidizing agents against settling, flocculation and decomposition. Surfactants may be anionic, cationic, nonionic, or amphoteric. It was found that the addition of a surfactant may be useful to improve the within-wafer-non-uniformity (WTWNU) of the wafers, thereby improving the surface of the wafer and reducing wafer defects.

US 4,752,628 discloses a lapping composition which contains:

| | % by weight |
|---|---|
| Finely divided inorganic abrasive | 5-70 |
| Biocide | 0.05-3 |
| Carboxylic acid dispersant polymer having a molecular weight of from 500-50,000 | 0.1-1 |
| Cross-linked carboxylic acid gel polymer thickener | 0.5-5 |
| Water soluble corrosion inhibitor | 0.5-5 |

EP 0 913 442A discloses a polishing solution containing an oxidizer and a substance which renders oxides water-soluble, but not containing a polishing abrasive or containing a polishing abrasive at a low concentration of less than 1 wt%

The present invention provides compounds that can be used in CMP slurries to prevent scratching, minimize surface roughness, and eliminate coating of gelled slurries or residue on the IC wafer surfaces. The chemical compounds listed in this patent work effectively with abrasive particles including, but not limited to, silicon dioxide, metal oxides and any other inorganic oxides, and mixtures of the like. The slurries of this invention work effectively on CMP processes for sheet wafers, pattern wafers with the films/lines of silicon dioxide (TEOS, BPSG, thermal oxide), low K polymers, silicon nitride and metals, as well as mixtures of the like.

### SUMMARY OF THE INVENTION

The invention provides an aqueous polishing composition for chemical mechanical polishing of semiconductor substrates having a pH under 5.0 that comprises a blend of at least two polyacrylic acids, wherein one polyacrylic acid has a low number average molecular weight of 20,000-100,000 and a second polyacrylic acid has a high number average molecular weight of 200,000-1,500,000; wherein the weight ratio of the low number average molecular weight polyacrylic acid to the high number average molecular weight polyacrylic acid is 10:1 to 1:10,
up to 3.0% by weight of abrasive particles, based on the weight of the composition,
1-15% by weight, based on the weight of the composition, of an oxidizing agent,
50-5000 parts per million by weight of an inhibitor, and
up to 3.0% by weight, based on the weight of the composition of a complexing agent.

A further aspect of this invention is the method of polishing a surface of a semiconductor wafer comprising the steps of:
(a) providing a polishing pad having a polishing surface;
(b) holding said wafer in a carrier such that the surface of the wafer is in contact with the polishing surface;
(c) moving said carrier to provide both pressure on the surface of the wafer and relative lateral motion between the surface of the wafer and the polishing surface; and
(d) providing the aqueous polishing composition of claim 1 at an interface between the surface of the wafer and the polishing surface.

The compositions of this invention may optionally further comprise one or more of the following: submicron abrasive particles, a dispersing agent and an oxidizing agent.

### DESCRIPTION OF THE PREFERRED EMBODIMENTS

Coating of polished IC wafer surfaces by preferentially adsorbed surfactants or polymers can significantly eliminate scratching and redeposition of residue. The coating layer, however, should be weakly bonded to the wafer surfaces, and be readily swept away by abrasion during CMP process, so that the materials removal rate will not be significantly reduced. The coating layers should also be readily rinsed off by DI water, or alkaline solutions in the post-CMP cleaning processes.

The slurries of this invention may optionally comprise a dispersant. Aqueous CMP slurries contain submicron abrasive particles. The size of these particles is important to the performance of the slurry as well as to the resultant surface quality. If the abrasive particles agglomerate, the polishing removal rates may change and the surface quality may deteriorate. Dispersants can be included in the slurry formulation to prevent this agglomeration of abrasive particles. Dispersants can be anionic, cationic, or nonionic. The selection of the proper dispersant depends on many factors including the surface characteristics of the abrasive particles and the ionic nature of the slurry formulation. Some examples of ionic surfactants include sodium lauryl sulfate, cetyl-trimethyl ammonium bromide. Amino alcohols are also used as dispersants in slurries for CMP.

An oxidizing agent is present in the compositions of the present invention. Examples of common oxidizing agents are nitrates, iodates, chlorates, perchlorates, chlorites, sulphates, persulphates, peroxides, ozonated water, and oxygenated water. An iodate is a preferred oxidizing agent. Another preferred oxidizing agent is hydrogen peroxide.

Any metal oxide or other polishing abrasive (such as alumina, ceria, zirconia, silica, titania, barium carbonate, or diamond) may be used in the slurries of this invention.

Preferably the complexing agent is malic acid.

This polyacrylic acid polishing composition is an aqueous composition having a pH of under 5.0 and preferably 2.8-4.2, and more preferably, 2.8-3.8. It has been found that a pH of 5.0 and above results in significant reduction in polishing of the copper in the semiconductor substrate

This polyacrylic acid composition preferably contains 0.05-1.0% by weight, based on the weight of the composition, of a blend or mixture of polyacrylic acids at least one having a relatively high number average molecular weight and the other or others having a relatively low number average molecular weight.

The number average molecular weight of the polyacrylic acid is determined by GPC (gel permeation chromatography).

The blend or mixture of two polyacrylic acids used has a low number average molecular weight polymer having a molecular weight of 20,000-100,000 and preferably 20,000-40,000. The high number average polyacrylic acid has a molecular weight of 200,000-1,500,000, preferably, 150,000-300,000. The weight ratio of the low molecular weight polyacrylic acid polymer to the high molecular weight polymer is 10:1 to 1:10, preferably 4:1 to 1:4, and more preferably 2:1 to 1:2.

In a preferred composition the blend consists of two polyacrylic acids, wherein one polyacrylic acid has a low number average molecular weight of 20,000-40,000 and a second polyacrylic acid has a high number average molecular weight of 200,000-300,000; wherein the weight ratio of the low number average molecular weight polyacrylic acid to the high number average molecular weight polyacrylic acid is 4:1 to 1:4.

One particularly preferred blend comprises a polyacrylic polymer having a low number average molecular weight of about 30,000 and a polyacrylic polymer having a high number average molecular weight of about 250,000 in a 1:1 weight ratio.

It is possible to use additional low molecular weight polyacrylic acids in the blend such as polyacrylic acids having a number average molecular weight of 1,000-5,000.

It is possible to use very high molecular weight polyacrylic acid polymers (molecular weight over 1,500,000) or crosslinked polyacrylic acid polymers in these polishing compositions as an additional additive, by properly adjusting polishing conditions and other components of the composition. Also, it may be possible to use these high molecular weight or crosslinked polyacrylic acids in place of the aforementioned blend of polyacrylic acids.

It is possible to use polymers of the acrylic group such as copolymers of acrylic acid, polymethacrylic acid, copolymers of methacrylic acid, polyacrylamides, acrylamide copolymers, polymethacrylamides, methacrylamide copolymers and a variety of other copolymers of the above and obtain an acceptable polishing composition.

Also, it is possible to form polyacrylic acid polymers that are biodegradeable, photodegradeable, or degradeable by other means that can be used in this invention for the polishing composition. An example of such a composition is a biodegradeable polyacrylic acid containing segments of poly(acrylate co methyl 2-cyanoacrylate).

The polyacrylic acid polishing composition can contain up to 3.0% by weight of abrasive particles described above Preferably, the composition does not contain such particles.

The polyacrylic acid polishing composition contains 1-15% by weight, preferably, 5-10% by weight, of an oxidizing agent such as hydrogen peroxide, iodates such as potassium iodate, nitrates such as cesium nitrate, barium nitrate, ammonium nitrate, mixtures of ammonium nitrate and cesium nitrate, carbonates such as ammonium carbonate, persulfates such as ammonium and sodium sulfate and perchlorates. Hydrogen peroxide is preferred in amounts of about 9% by weight.

The polyacrylic acid composition contains up to 3.0% and preferably, 0.1-1.0% of a complexing agent such as carboxylic acids containing two or more carboxylate groups with hydroxy groups as disclosed in Brancaleoni et al US Patent 5,391,258 issued Feb. 21, 1995. Typical complexing agents include straight chain mono-and dicarboxylic acids and their salts such malic acid and malates, tartaric acid and tartarates, gluconic acid and gluconates, citric acid and citrates, malonic acid and malonates, formic acid and formates, lactic acid and lactates. Polyhydroxybenzoic acid and acid salts, phthalic acid and acid salts also can be used.

The polyacrylic acid composition also contains 50-5,000 ppm (parts per million by weight) of an inhibitor such as BTA (benzotriazole) and TTA (tolyltriazole) or mixtures thereof that are preferred. Other inhibitors that can be used are 1-hydroxybenzotriazole, N-(1H-benzotriazole-1-ylmethyl)formamide, 3,5-dimethylpyrazole, indazole, 4-bromopyrazole, 3-amino-5-phenylpyrazole, 3-amino-4-pyrazolecarbonitrile, 1-methyimidazole, Indolin QTS and the like.

The polyacrylic acid composition may contain pH buffers such as amines, and may contain surfactants, deflocculants, viscosity modifiers, wetting agents, cleaning agents and the like.

The following are typical polishing pads that can be used with the novel polishing composition and with the polyacrylic acid composition of this invention to polish semiconductors: metals pad described in Roberts et at US Patent 6,022,268 issued Feb. 8, 2000, pads containing polishing particles described in Cook et al US Patent 6,022,264 issued Feb. 8, 2000, pads described in Cook et al US Patent 5,489,233 issued Feb. 6, 1996, polymer impregnated fiber matrices typified by pads sold by Rodel, Inc. under the trade name SUBA, pads of a polymer sheet containing void spaces effected by in situ production or incorporation of hollow filler materials (typically pads sold by Rodel, Inc. under the trade names POLITEX AND IC1010), pads of polymer sheets containing solid particles added as filers, which may optionally contain void spaces, effected either by in situ production or by incorporation of hollow filler materials (typically pads sold by Rodel Inc. under the trade names MH), and composite pads consisting of multiple layers of materials whose outer substrate contacting surface consists of a pad selected from one of the above.

In the examples presented below, we demonstrate the reduction of wafer surface tension resulting from the adsorption of the above mentioned additives in the slurries. Examples of the surface roughness improvement and prevention of slurry/residue redeposit are also given. All parts and percentages are on a weight basis and molecular weights are determined by gel permeation chromatography unless otherwise indicated.

### Example 1 Polyacrylic acid polishing compositions

An aqueous polishing Composition 1 was prepared by blending together the following constituents: 0.22 parts malic acid, 3000 ppm (part per million) benzotriazole, 9.0 parts hydrogen peroxide with water to provide 100 parts of the composition and the pH was adjusted to 3.1. Then 0.09 parts polyacrylic acid having a number average molecular weight of 250,000 and 0.09 parts polyacrylic acid having a number average molecular weight of 30,000 were added.

A Mira polishing machine was used under the following conditions: 34.5 kPa (5 psi). down force, 100 rpm platen speed and 90 rpm head speed for 40 seconds; the second stage of polishing was 34.5 kPa (5 psi) down force, 100 rpm platen speed, 25 rpm head speed for 40 seconds; and the third stage of polishing was 2 psi down force, 100 rpm platen speed and 90 rpm head speed for 220 seconds. The pad used was a Metals 26 pad made by Rodel Inc. and described in US Patent 6,022,268. The pad was preconditioned for 30 minutes with a 149µm (100 grit) diamond disk (manufactured by Abrasives Technology, Inc.) and conditioned for 20 seconds between polishing of wafers.

The test wafers polished were silicon wafers having a silicon dioxide layer with copper trenches or lines each having a width of 10 µm, 25 µm and 100 µm and a thin copper layer was deposited on top of the wafer.

After polishing the dishing of each of the lines was measured at the center, middle and edge of the line and an average was determined. Because the polishing composition has high copper to barrier selectivity, the copper removal essentially stops when the barrier is reached. Therefore the results reported in the following Table I include the barrier thickness. The results as shown below in Table 1 are considered acceptable.

An aqueous polishing Composition 2 was prepared which was identical to Composition 1 except the following mixture of polyacrylic acids was used: 0.09% Polyacrylic Acid MW 1,250,00+0.09% Polyacrylic Acid MW 30,000. Polishing was carried out as above and the results are acceptable and shown in Table 1 below.

An aqueous polishing Composition 3 was prepared which was identical to Composition 1 except the following mixture of polyacrylic acids was used: 0.09% Potyacrylic Acid MW 750,000 + 0.09% Polyacrylic Acid MW 30,000. Polishing was carried out as above and the results are acceptable and shown in Table 1 below.

An aqueous polishing Composition 4 was prepared identical to Composition 1 except all of the benzotriazole was replaced with tolyhriazole. Polishing was carried out under the following conditions: 34.5 kPa (5 psi) down *force,* 100 rpm platen speed and 90 rpm head speed for 60 seconds; the second stage of polishing was 34.5 kPa (5 psi) down force, 100 rpm platen speed, 25 rpm head speed for 60 seconds; and the third stage of polishing was 13.8 kPa (2 psi) down force, 100 rpm platen speed and 90 rpm head speed for 115 seconds. The polishing results are acceptable and shown in Table 1 below.

**TABLE 1**

| Composition 1 | | |
|---|---|---|
| (0.09% 250,000 MW Polyacrylic Acid + 0.09% 30,000 MW Polyacrylic Acid) | | |
| 10 µm line | 25 µm line | 100 µm line |
| Ave. 391 | Ave. 493 | Ave. 943 |

| Composition 2 | | |
|---|---|---|
| (0.09% 1,250,000 MW Polyacrylic Acid +0.09% 30,000 MW Polyacrylic Acid) | | |
| 10µm line | 25µm line | 100µm line |
| Ave. 316 | Ave. 383 | Ave. 637 |

| Composition 3 | | |
|---|---|---|
| (0.09% 750,000 MW Polyacrylic Acid + 0.09% 30,000 MW Polyacrylic Acid) | | |
| 10µm line | 25 µm line | 100 µm line |
| Ave. 416 | Ave. 441 | Ave. 940 |

| Composition 4 | | |
|---|---|---|
| (Identical to Composition 1 except tolyltriazole was substituted for benzotriazole) | | |
| 10µm line | 25µm line | 100µm line |
| Ave. 354 | Ave. 503 | Ave. 757 |

### EXAMPLE 2 (COMPARATIVE EXAMPLE)

The following polishing compositions containing polyacrylic acid illustrate compositions that do not provide adequate polishing results:

### Composition 5

The composition is identical to Composition 1 except that 0.18% polyacrylic acid having a number average molecular weight of 1,800 was substituted for the polyacrylic acid blend used in Composition 1. Polishing was done in an identical manner as used with Composition 1 except the third stage of polishing was continued for 500 seconds. Polishing was inadequate since there was no removal of copper from the wafer.

### Composition 6

The composition is identical to Composition 1 except that 0.18% polyacrylic acid having a number average molecular weight of 250,000 was substituted for the polyacrylic acid blend used in Composition 1. Polishing was done in an identical manner as used with Composition 1.

The results were as follows: 10µm - 725, 25 µm-958, 100 µm-1581. The results obtained for the 100µm line is considered unacceptable.

### Composition 7

The composition is identical to Composition 1 except that the pH was adjusted to 5.5. Polishing was done in an identical manner as used with Composition 1. Polishing was inadequate since there was no removal of copper from the wafer.

## Claims

1. An aqueous polishing composition for chemical mechanical polishing of semiconductor substrates having a pH under 5.0 that comprises a blend of at least two polyacrylic acids, wherein one polyacrylic acid has a low number average molecular weight of 20,000 - 100,000 and a second polyacrylic acid has a high number average molecular weight of 200,000 - 1,500,000; wherein the weight ratio of the low number average molecular weight polyacrylic acid to the high number average molecular weight polyacrylic acid is 10:1 to 1:10, up to 3.0% by weight of abrasive particles, based on the weight of the composition,
1-15 % by weight, based on the weight of the composition, of an oxidizing agent,
50-5000 parts per million by weight of an inhibitor, and
up to 3.0% by weight, based on the weight of the composition of a complexing agent.

2. The aqueous polishing composition of claim 1 in which the blend consists of two polyacrylic acids, wherein one polyacrylic acid has a low number average molecular weight of 20,000 - 40,000 and a second polyacrylic acid has a high number average molecular weight of 200,000 - 300,000; wherein the weight ratio of the low number average molecular weight polyacrylic acid to the high number average molecular weight polyacrylic acid is 4:1 to 1:4

3. The aqueous polishing composition of claim 1 in which the oxidizing agent consists of hydrogen peroxide.

4. The aqueous polishing composition of claim 1 in which the inhibitor is from the group of benzotriazole, tolyltriazole or mixtures thereof.

5. The aqueous polishing composition of claim 1 in which the complexing agent is a carboxylic acid having at least two carboxyl groups and a hydroxyl group.

6. The aqueous polishing composition of claim 1 having a pH of 2.8 to 4.2 in which the blend consists of two polyacrylic acids, wherein one polyacrylic acid has a low number average molecular weight of 20,000 - 40,000 and a second polyacrylic acid has a high number average molecular weight of 200,000 - 300,000; wherein the weight ratio of the low number average molecular weight polyacrylic acid to the high number average molecular weight polyacrylic acid is 4:1 to 1:4, the oxidizing agent consists of hydrogen peroxide, the inhibitor is from the group of benzotriazole, tolyltriazole or any mixtures thereof and the complexing agent is a carboxylic acid having two carboxyl groups and a hydroxyl group.

7. A method of polishing a surface of a semiconductor wafer comprising the steps of:
(a) providing a polishing pad having a polishing surface;
(b) holding said wafer in a carrier such that the surface of the wafer is in contact with the polishing surface;
(c) moving said carrier to provide both pressure on the surface of the wafer and relative lateral motion between the surface of the wafer and the polishing surface; and
(d) providing the aqueous polishing composition of claim 1 at an interface between the surface of the wafer and the polishing surface.

## Patentansprüche

1. Wäßrige Polierzusammensetzung zum chemisch-mechanischen Polieren von Halbleitersubstraten mit einem pH-Wert unter 5,0, welche
eine Mischung von mindestens zwei Polyacrylsäuren, wobei eine Polyacrylsäure ein niedriges zahlenmittleres Molekulargewicht von 20.000-100.000 aufweist und eine zweite Polyacrylsäure ein hohes zahlenmittleres Molekulargewicht von 200.000-1.500.000 aufweist, wobei das Gewichtsverhältnis der Polyacrylsäure mit dem niedrigen zahlenmittleren Molekulargewicht zu der Polyacrylsäure mit dem hohen zahlenmittleren Molekulargewicht von 10:1 bis 1:10 ist,
bis zu 3,0 Gew.-% Schleifmittelteilchen, bezogen auf das Gewicht der Zusammensetzung,
1-15 Gew.-% eines Oxidationsmittels, bezogen auf das Gewicht der Zusammensetzung,
50-5.000 Gewichtsteile pro Million eines Inhibitors, und
bis zu 3,0 Gew.-% eines Komplexierungsmittels, bezogen auf das Gewicht der Zusammensetzung umfaßt.

2. Wäßrige Polierzusammensetzung nach Anspruch 1, in welcher die Mischung aus zwei Polyacrylsäuren besteht, wobei eine Polyacrylsäure ein niedriges zahlenmittleres Molekulargewicht von 20.000-40.000 aufweist und eine zweite Polyacrylsäure ein hohes zahlenmittleres Molekulargewicht von 200.000-300.000 aufweist, wobei das Gewichtsverhältnis der Polyacrylsäure mit dem niedrigen zahlenmittleren Molekulargewicht zu der Polyacrylsäure mit dem hohen zahlenmittleren Molekulargewicht 4:1 bis 1:4 ist.

3. Wäßrige Polierzusammensetzung nach Anspruch 1, in welcher das Oxidationsmittel aus Wasserstoffperoxid besteht.

4. Wäßrige Polierzusammensetzung nach Anspruch 1, in welcher der Inhibitor aus der Gruppe Benzotriazol, Tolyltriazol oder Mischungen davon ist.

5. Wäßrige Polierzusammensetzung nach Anspruch 1, in welcher das Komplexierungsmittel eine Carbonsäure mit mindestens zwei Carboxylgruppen und einer Hydroxylgruppe ist.

6. Wäßrige Polierzusammensetzung nach Anspruch 1 mit einem pH-Wert von 2,8 bis 4,2, in welcher die Mischung aus zwei Polyacrylsäuren besteht, wobei eine Polyacrylsäure ein niedriges zahlenmittleres Molekulargewicht von 20.000-40.000 aufweist und eine zweite Poylacrylsäure ein hohes zahlenmittleres Molekulargewicht von 200.000-300.000 aufweist, wobei das Gewichtsverhältnis der Polyacrylsäure mit dem niedrigen zahlenmittleren Molekulargewicht zu der Polyacrylsäure mit dem hohen zahlenmittleren Molekulargewicht von 4:1 bis 1:4 ist, das Oxidationsmittel aus Wasserstoffperoxid besteht, der Inhibitor aus der Gruppe Benzotriazol, Tolyltriazol oder irgendwelchen Mischungen davon ist und das Komplexierungsmittel eine Carbonsäure mit zwei Carboxylgruppen und einer Hydroxylgruppe ist.

7. Verfahren zum Polieren einer Oberfläche eines Halbleiterwafers, umfassend die Schritte
(a) des Bereitstellens eines Polierkissens mit einer Polieroberfläche,
(b) des Haltens des Wafers in einem Träger dergestalt, daß die Oberfläche des Wafers in Kontakt mit der Polieroberfläche ist,
(c) des Bewegens des Trägers, um sowohl Druck auf die Oberfläche des Wafers als auch eine relative laterale Bewegung zwischen der Oberfläche des Wafers und der Polieroberfläche auszuüben, und
(d) des Bereitstellens der wäßrigen Polierzusammensetzung nach Anspruch 1 in einer Grenzfläche zwischen der Oberfläche des Wafers und der Polieroberfläche.

## Revendications

1. Composition aqueuse de polissage pour polissage mécanique et chimique de substrats semi-conducteurs ayant un pH inférieur à 5.0 qui comprend un mélange d'au moins deux acides polyacryliques, **caractérisée en ce qu'**un acide polyacrylique a une faible masse moléculaire moyenne en nombre de 20.000-100.000 et le second acide polyacrylique a une masse moléculaire moyenne en nombre élevée de 200.000-1.500.000 ; dans laquelle le rapport en poids de l'acide polyacrylique de faible masse moléculaire moyenne en nombre sur l'acide polyacrylique de masse moléculaire moyenne en nombre élevée varie de 10/1 à 1/10,
jusqu'à 3,0 % en poids de particules abrasives par rapport au poids de la composition.
1-15 % en poids, par rapport au poids de la composition d'un agent oxydant,
50-5000 parties par million en poids d'un inhibiteur, et
jusqu'à 3,0 % en poids par rapport au poids de la composition d'un agent complexant.

2. Composition aqueuse de polissage selon la revendication 1, **caractérisée en ce que** le mélange consiste en deux acides polyacryliques, dans lequel un acide polyacrylique a une faible masse moléculaire moyenne en nombre de 20.000-40.000 et le second acide polyacrylique a une masse moléculaire moyenne en nombre élevée de 200.000-300.000 ; dans laquelle le rapport en poids de l'acide polyacrylique de faible masse moléculaire moyenne en nombre sur l'acide polyacrylique de masse moléculaire moyenne en nombre élevée varie de 4/1 à 1/4.

3. Composition aqueuse de polissage selon la revendication 1 **caractérisée en ce que** l'agent oxydant consiste en du peroxyde d'hydrogène.

4. Composition aqueuse de polissage selon la revendication 1 **caractérisée en ce que** l'inhibiteur est du groupe du benzotriazole, du tolyltriazole ou de leurs mélanges.

5. Composition aqueuse de polissage selon la revendication 1 **caractérisée en ce que** l'agent complexant est un acide carboxylique ayant au moins deux groupes carboxyles et un groupe hydroxyle.

6. Composition aqueuse de polissage selon la revendication 1, ayant un pH de 2,8 à 4,2, **caractérisée en ce que** le mélange consiste en deux acides polyacryliques, dans lequel un acide polyacrylique a une faible masse moléculaire moyenne en nombre de 20.000-40.000 et le second acide polyacrylique a une masse moléculaire moyenne en nombre élevée de 200.000-300.000 ; dans laquelle le rapport en poids de l'acide polyacrylique de faible masse moléculaire moyenne en nombre sur l'acide polyacrylique de masse moléculaire moyenne en nombre élevée varie de 4/1 à 1/4, l'agent oxydant consiste en du peroxyde d'hydrogène, l'inhibiteur est du groupe du benzotriazole, du tolyltriazole ou de leurs mélanges et l'agent complexant est un acide carboxylique ayant au moins deux groupes carboxyles et un groupe hydroxyle.

7. Procédé de polissage de la surface d'une plaquette semi-conductrice comprenant les étapes :
(a) apport d'un tampon polisseur ayant une surface polisseuse;
(b) maintien de ladite plaquette dans un support de telle sorte que la surface de la plaquette soit en contact avec la surface polisseuse ;
(c) déplacement dudit support pour amener à la fois une pression sur la surface de la plaquette et un mouvement latéral relatif entre la surface de la plaquette et la surface polisseuse ; et
(d) apport de la composition aqueuse de polissage selon la revendication 1 à une interface entre la surface de la plaquette et la surface de polissage.
